# EUROPEAN PATENT APPLICATION

(11) **EP 1 905 953 A2**
(43) Date of publication of application: **02.04.2008**
(21) Application number: 07252220.4
(22) Date of filing: 31.05.2007
(51) Int. Cl.: F01D 5/28, C21D 7/08

(54) **Low plasticity burnishing of coated titanium parts**

(30) Priority: 02.06.2006 US 446430
(71) Applicant: United Technologies Corporation, Hartford, CT 06101 (US)
(72) Inventor: Rutz, David A., Glastonbury, CT 06033 (US); Kinstler, Monika D., Glastonbury, CT 06033 (US)
(74) Representative: Leckey, David Herbert

(57) **Abstract**

A Ti-based coating (20) may have embedded defects (26). The defects (26) may impart one or more structural weakness to the coating and coated part. The coating (20) is subjected to a burnishing process to impart a residual compressive stress to mitigate one or more of these structural weaknesses.

## Description

### BACKGROUND OF THE INVENTION

The invention relates to deposition of Ti-based materials. More particularly, the invention relates to addressing deposition defects.

A growing art exists regarding the deposition of Ti-based materials. For example, electron beam physical vapor deposition (EBPVD) may be used to build a coating or structural condensate of a Ti alloy atop a substrate of like or dissimilar nominal composition. Such techniques may be used in the aerospace industry for the restoration of damaged or worn parts such as gas turbine engine components (e.g., blades, vanes, seals, and the like).

Deposition defects, however, potentially compromise the condensate integrity. One group of such defects arises when a droplet of material is spattered onto the substrate or the accumulating condensate. Such defects are commonly known as "spits". The melt pool may contain additives not intended to vaporize and accumulate in the condensate. For example, U.S. Patent No. 5,474,809 discloses use of refractory elements in the melt pool. Once the droplet lands on the surface (of the substrate or the accumulating condensate) further deposition builds atop the droplet and the adjacent surface. Along the sides of the droplet, there may be microstructural discontinuities in the accumulating material due to the relative orientation of the sides of the droplet. As further material accumulates, these discontinuities may continue to build all the way to the final condensate surface.

### SUMMARY OF THE INVENTION

A Ti-based coating may have embedded defects. The defects may impart one or more structural weakness to the coating and coated part. The coating is subjected to a burnishing process to impart a residual compressive stress to mitigate one or more of these structural weaknesses.

The details of one or more embodiments of the invention are set forth in the accompanying drawings and the description below. Other features and advantages of the invention will be apparent from the description and drawings, and from the claims.

### BRIEF DESCRIPTION OF THE DRAWINGS

FIG. 1 is an optical micrograph of a Ti-6Al-4V condensate atop a like substrate and showing defects.
FIG. 2 is a view of a blade.
FIG. 3 is a flowchart of a first process for restoring the blade.
FIG. 4 is a flowchart of a second process for restoring the blade.

Like reference numbers and designations in the various drawings indicate like elements.

### DETAILED DESCRIPTION

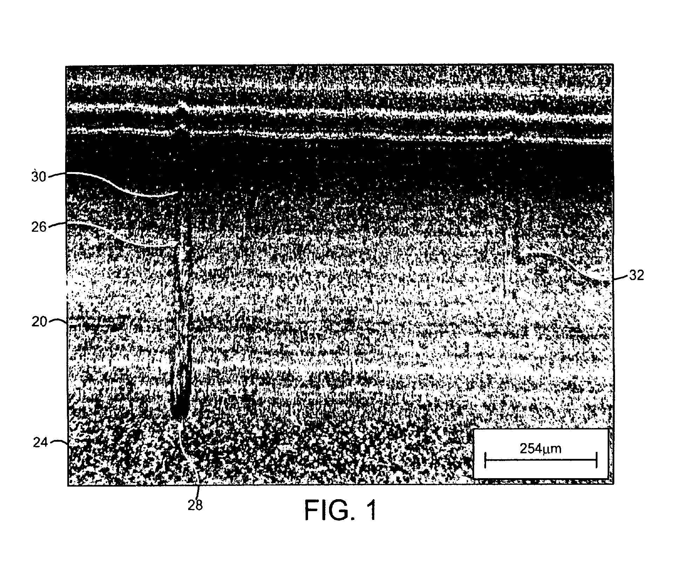

FIG. 1 shows a condensate 20 accumulated atop a surface 22 of a substrate 24. Exemplary condensate thickness may be from less than 0.2mm (e.g., for thin coatings) to in excess of 2mm (at least locally - e.g., for structural condensates such as certain restorations). The condensate has a first defect 26 triggered by a spattered molybdenum droplet 28 that landed atop the surface 22. Exemplary droplet sizes are 30-500µm (measured as a characteristic (mean/median/mode) transverse dimension). The defect (spit) comprises a trunk 30 extending from the droplet 28 toward the condensate surface (not shown). A second defect 32 is shown and may have been triggered by a droplet below the cut surface of the view. Other defects may not necessarily be caused by spattering. For example, voids or bubbles may cause similar spits.

The exemplary deposition is of nominal Ti-6Al-4V condensate atop a like substrate. Alternate depositions may include Ti-6Al-2Sn-4Zr-2Mo and Ti-8Al-1Mo-1V. The deposition may be from a melted ingot at least partially through a pool containing one or more refractory or other elements, which may be essentially non-consumed during deposition (e.g., a pool formed from a 30%Mo-70%Zr mixture). Accordingly, the droplets may tend to have compositions similar to the surface layers of the pool. In the absence of the non-consumed pool additive, the droplet 28 might have a similar composition to the ingot yet still produce similar defects. Many droplets in systems using an Mo-containing pool would have Mo concentrations of at least 10% by weight; others at least 20%. This may be somewhat less than the Mo percentage of the non-expending pool material to reflect possible dilution by deposition material elements in the pool.

In the exemplary implementation, the substrate 28 has an α-β microstructure of medium to coarse grains (e.g., 10-40µm characteristic grain size (e.g., mean) or about ASTM 10.5-6.5). An exemplary 10-20% by weight of the substrate is β phase with the remainder essentially α phase. The condensate matrix (away from the defects) also has an α-β microstructure but of very fine grains (e.g., acicular α grains of 5-10µm in length and 2-5µm in thickness, lengthwise oriented along the condensate growth/deposition direction). The trunk size will depend, in substantial part, upon the droplet size. Exemplary trunk diameters are from about 20µm to about 50µm. However, much larger trunks are possible. The trunks have a columnar α-β microstructure. This microstructure may have a characteristic grain size several times greater than that in the matrix and the grains may be elongated in the direction of accumulation (i.e., away from the substrate). Particularly in the case of very large diameter trunks (e.g., in excess of 100µm in diameter), there may be porosity around the trunk. The grain discontinuity at the trunk-matrix interface and the particular alignment of trunk grains may cause structural weaknesses affecting, *inter alia,* ductility, fracture toughness, fatigue resistance, fretting fatigue resistance, corrosion resistance, wear resistance, crack nucleation resistance, and the like.

According to the present invention, the condensate is subjected to a burnishing process to mitigate one or more of these structural weaknesses. The exemplary burnishing process is a low plasticity burnishing process.

Low plasticity burnishing of aerospace parts is discussed in U.S. Patent Nos. 5,826,453, 6,672,838, and 6,893,225 and Published Application No. 2005-0155203. Use of such burnishing for Ti-based parts is also discussed in P. Prevéy, N. Jayaraman, and R. Ravindranath, "Use of Residual Compression in Design to Improve Damage Tolerance in Ti-6Al-4V Aero Engine Blade Dovetails," Proc. 10th Nat. HCF Conf., New Orleans, LA, Mar. 8-11, 2005 and P. Prevéy, N. Jayaraman, and J. Cammett, "Overview of Low Plasticity Burnishing for Mitigation of Fatigue Damage Mechanisms," Proceedings of ICSP 9, Paris, Marne la Vallee, France, Sept. 6-9, 2005.

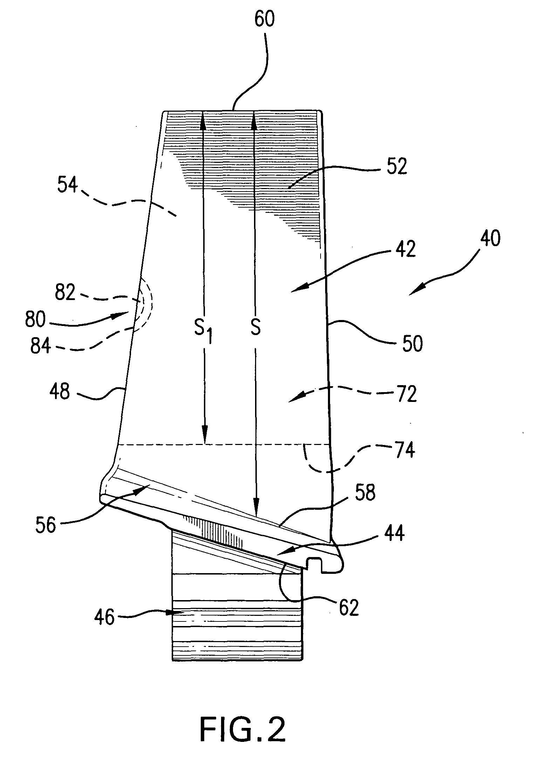

An exemplary part is a blade 40 (FIG. 2). The exemplary blade has an airfoil 42, a platform 44, and an attachment root 46. The airfoil has a leading edge 48, a trailing edge 50, and pressure and suction sides 52 and 54 extending between the leading and trailing edges. The airfoil extends from an inboard end 56 at the platform outboard surface 58 to an outboard end or tip 60. The root depends from an underside 62 of the platform and may have a convoluted profile (e.g., so-called dovetail or fir tree profiles) for securing the blade to a complementary slot of a disk (not shown). A local span S is the radial distance between the tip 60 and the airfoil inboard end 56. The span S will vary along the airfoil chord.

An exemplary airfoil may be subject to one or more forms of wear and/or damage. Wear may include widely distributed erosion. Damage may include nicks and chips from foreign object damage (FOD), usually near the leading edge or at the tip.

To address distributed erosion, the condensate (coating) 20 may be applied to a zone 72. An exemplary zone 72 extends along substantially an entirety of the airfoil along the pressure and suction sides to a boundary 74. The exemplary boundary 74 is a radial distance S₁ from the tip. Exemplary S₁ is more than 50% of S along the entire chord.

FIG. 2 also shows an exemplary damage site 80 along the leading edge 48. For a weld restoration, a weld restoration material 82 is shown atop the site to replace lost material. Exemplary weld restorations may be of build-up type and/or may include a pre-formed prosthesis. Adjacent the weld material, the existing substrate may be subject to thermally-induced thinning or localized weld shrinkage along a zone 84. The condensate may, alternatively or additionally, be applied to the zone 84 to restore thickness lost through localized weld shrinkage.

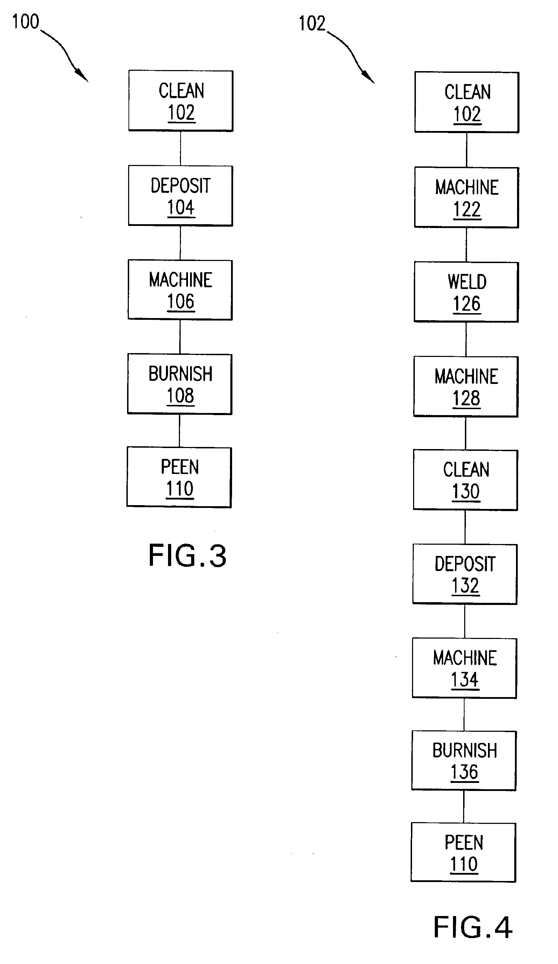

For an exemplary erosion restoration 100 (FIG. 3), an initial cleaning 102 may comprise an etch in an HF and HNO₃ solution. The cleaning may also include mechanical cleaning. After the cleaning, the condensate is deposited 104.

In the exemplary method, a finish machining 106 of the condensate may locally bring the final airfoil contour within specification. Exemplary machining 106 involves use of an abrasive belt sander with hand manipulation of the blade relative to the sander. Alternative machining by automated blending processes is also known. An inspection (e.g., probe or laser scan, not shown) may verify dimensional compliance of the part.

The condensate is subjected to a burnishing 108. Exemplary burnishing is by fluid rolling elements. Exemplary rolling elements are spheres/balls. Single point burnishing and opposed two-point caliper burnishing are disclosed in the references cited above. Alternatively, the burnishing may be performed before or in the absence of the finish machining 106.

The exemplary burnishing is over essentially the entire condensate with slight overlap onto the uncovered area of the airfoil. The exemplary burnishing is shallow (i.e., imparting residual compressive stress not extending through the entire thickness/depth of the substrate). An exemplary as-applied condensate has a median/modal thickness of 0.008 inches (0.2 mm) (more broadly up to about 0.015 inch (0.38 mm), more narrowly 0.004-0.015 inch (0.1 to 0.38 mm), and more narrowly 0.004-0.008 inch (0.1 to 0.2 mm)). An exemplary burnishing imparts a residual compressive stress over a depth zone extending to or slightly below the condensate-substrate interface at the surface 22. An exemplary depth zone is 1.0-2.0 times the local coating thickness. Typically the depth zone is no more than 0.020 inch (0.51 mm).

An exemplary residual stress in the zone has a peak value of 100-110ksi for Ti-6-4, more broadly 100-120 ksi, more broadly 90-120ksi. The upper end of the range may be limited by the strength of the condensate. Below the zone, the residual stress will drop off. The exemplary stress may be at least 20ksi at the condensate/substrate interface. Below the interface the stress will further drop. The stress may be below 20ksi and, more narrowly, may reach zero within an exemplary 0.001-0.005 inch (0.025 to 0.127 mm) (more narrowly 0.001-0.004 inch (0.025 to 0.1 mm)) below the interface, especially for coatings machined post burnishing or coatings where pre-burnishing machining has not substantially reduced coating thickness. Depending on coating thickness and the timing and extent of such machining, this location (below 20ksi and, more narrowly, zero) may be within an exemplary 0.015 inch (0.38 mm) (more narrowly, 0.012 inch (0.3 mm) (e.g., 0.009-0.012 inch (0.23 to 0.3 mm) for no or minimal post-burnish machining)) of the condensate surface. Such a shallow depth of stress distribution may limit distortion of the part.

The burnishing parameters needed to provide the desired stress distribution may be developed through an iterative destructive testing process. In an exemplary testing process, a localized inspection process (e.g., x-ray diffraction) may be used to evaluate the depth and magnitude distribution of the residual stress and may indicate the need for altering the burnishing parameters for the location.

In the exemplary method, there may be a further mechanical treatment of the areas of the blade beyond those covered by the condensate and subject to the burnishing. For example, there may be a shot peening 110. The shot peening may address the attachment root 46. The shot peening may provide a stress distribution that is shallower, but of higher peak compression than the burnishing.

Among possible variations are reorderings of the burnishing, machining, and/or shot peening.

FIG. 4 shows an exemplary weld restoration 120. Steps similar to those of the restoration 100 are shown with like reference numerals. The damage site may be machined 122 before or after the cleaning 102. The welding 126 may replace lost material. A post-weld machining 128 may reduce raised areas of the weld and prepare the shrinkage zone for deposition and may be similar to the machining 106. A re-clean 130 may precede the deposition 132.

The deposition may cover the shrinkage zone, with slight overlap onto unaffected areas. An alternative deposition may be broader, (e.g., covering a similar area to that of the deposition 104). Deposition thickness may be similar to that of the deposition 104. A post-deposition machining 134 (e.g., also similar to 106) may be performed.

Burnishing 136 (e.g., similar to 108) may cover the condensate with slight overlap onto unaffected areas or may be of a broader extent such as that of the burnishing 108. Shot peening 110 may similarly follow. As with the first example, burnishing parameters may be determined by appropriate testing.

One or more embodiments of the present invention have been described. Nevertheless, it will be understood that various modifications may be made without departing from the scope of the invention. For example, the invention may be implemented as a modification of or using various existing deposition, welding, machining, burnishing, and other techniques and apparatus. Also, various boundary and transition areas may have properties departing from those discussed above. Although illustrated as applied to a blade airfoil, the Ti-based coatings may be on other areas and other components. Other blade examples involve restoration of worn or fretted blade roots. Accordingly, other embodiments are within the scope of the following claims.

## Claims

1. In a method of making an article of a metallic material, the article comprising a Ti-based substrate (24) having a surface (22) and Ti-based coating (20) covering at least a portion of the surface (22), the steps of:
selecting a portion of a surface of the article; and then,
performing roller deformation on the portion until a compressive stress is provided through a first depth along the portion.

2. The method of claim 1 for making a blade (40) in which:
the portion is along an airfoil (42) of the blade (40).

3. The method of claim 2 wherein:
the portion includes an area within an inboard half of a span of the airfoil (42).

4. The method of claim 3 wherein:
the portion is a majority of a surface area of the airfoil (42).

5. The method of any preceding claim wherein:
the first depth is no more than 0.020 inch (0.51 mm); and
a peak compressive stress is 100-120ksi.

6. The method of claim 5 wherein:
the compressive stress is at least 20ksi at a coating/substrate interface.

7. The method of any preceding claim wherein along a majority of an area of the coating:
the first depth is 0.004-0.015 inch (0.1 to 0.38 mm); and
the first depth is at least a local coating thickness.

8. A component (40) having:
a Ti-based metallic substrate (24); and
a Ti-based condensate (20) atop the substrate (24) and having:
a surface;
a plurality of embedded inclusions (26) below the surface; and
along a first region, a compressive stress greater than 20ksi in a first depth zone extending from the condensate (20) into the substrate (24).

9. The component of claim 8 wherein:
the condensate (20) and the substrate (24) consist essentially of an alloy of 5-7 weight percent aluminum, 3-5 weight percent vanadium, balance titanium, with less than 3 weight percent other components.

10. The component of claim 8 or 9 wherein:
along the first region, said compressive stress is greater than 20ksi essentially from the surface to a depth of at least 0.005 inch (0.127 mm) but not more than 0.015 inch (0.38 mm).

11. The component of claim 8, 9 or 10 wherein:
along the first region, said compressive stress drops below 20ksi within 0.005 inch (0.127 mm) of a condensate/substrate interface.

12. The component of any of claims 8 to 11 wherein:
along the first region, the condensate (20) has a thickness of at 0.002-0.010 inch (0.05 mm to 0.25 mm).

13. The component of any of claims 8 to 12 wherein:
along the first region, the condensate (20) has a first thickness and the first depth zone has a thickness of 1.0-2.0 times said first thickness.

14. The component of claim 13 wherein:
the first region is a majority of the surface area occupied by the condensate (20).

15. A method for treating a deposited titanium-base material, the material initially having:
a matrix having first nominal chemistry and a first characteristic grain size and first characteristic grain structure; and
a plurality of discontinuities (26) within the matrix, the method comprising:
burnishing the material.

16. The method of claim 15 wherein the discontinuities include:
a plurality of spits (26) within the matrix and having:
a droplet (28) having a higher level of refractory impurities than the matrix; and
a trunk (30) extending from the droplet and having essentially the same chemistry as the matrix, but a larger second characteristic grain size and less equiaxed second grain structure.

17. The method of claim 15 or 16 wherein the material is atop a substrate (24) and the burnishing provides:
a compressive stress of 20-120ksi along a first depth zone of at least a local thickness of the material but not more than 0.015 inch (0.38 mm).

18. The method of claim 15, 16 or 17 wherein the material is atop a substrate and the burnishing provides:
a compressive stress of 20-120ksi along a first depth zone of at 1.0-2.0 times a local thickness of the material.

19. The method of any of claims 15 to 18 wherein the burnishing comprises fluid roller burnishing.

20. The method of any of claims 15 to 19 further comprising depositing said material atop a substrate (24) by at least one of electron beam physical vapor deposition, cathodic arc deposition and sputtering.

21. The method of any of claims 15 to 20 wherein the material is atop a first area of a substrate (24) and the method further comprising shot peening the substrate on a second area not covered by the material.

22. The method of claim 21 wherein the shot peening provides a residual stress with a higher magnitude and lower depth than does the burnishing.

23. The method of claim 21 or 22 performed on a blade (40) wherein the first area is along an airfoil (42) of the blade (40) and the second area is along an attachment root (46).

24. The method of claim 23 further comprising:
cleaning the blade (40);
machining the substrate (24) at a damage site;
welding a prosthesis to the damage site;
post-welding machining at the site;
depositing the material after said post-welding machining; and
machining excess of the material.

25. The method of claim 23 or 24 further comprising:
cleaning the blade;
depositing the material after said cleaning; and
machining excess of the material.

26. The method of claim 23, 24 or 25 wherein:
the machining is an abrasive machining; and
the machining is before the burnishing.
